# EUROPÄISCHE PATENTSCHRIFT

(11) **EP 0 839 389 B1**
(45) Veröffentlichungstag und Bekanntmachung des Hinweises auf die Patenterteilung: **27.02.2002**
(21) Anmeldenummer: 96923832.8
(22) Anmeldetag: 11.07.1996
(51) Int. Cl.: H01L 27/02

(54) **INTEGRIERTE SCHALTUNG**
INTEGRATED CIRCUIT
CIRCUIT INTEGRE

(30) Priorität: 20.07.1995 DE 19526566
(43) Veröffentlichungstag der Anmeldung: 06.05.1998
(73) Patentinhaber: Infineon Technologies AG, 81669 München (DE)
(72) Erfinder: HEBBEKER, Heinz, D-82435 Bayersoien (DE); RECZEK, Werner, D-85521 Ottobrunn (DE); SAVIGNAC, Dominique, D-85737 Ismaning (DE); TERLETZKI, Hartmud, D-81827 München (DE)
(74) Vertreter: Epping, Wilhelm, Dipl.-Ing.
(86) Internationale Anmeldenummer: DE9601258
(87) Internationale Veröffentlichungsnummer: WO9704484

(56) Entgegenhaltungen:
- EP-A- 0 217 525
- EP-A- 0 253 105
- EP-A- 0 444 686

## Beschreibung

Die Erfindung betrifft eine integrierte Schaltung.

Integrierte Schaltungen müssen gegen elektrostatische Entladungen (ESD) geschützt werden. Hierfür sind ihre Anschlußpins im allgemeinen mit entsprechenden Schutzstrukturen versehen. Bei den ESD-Schutzstrukturen handelt es sich zumeist um Feldoxidtransistoren, die zwischen den Anschlußpads und den Versorgungspotentialen der Schaltung angeordnet werden. Aufgabe der ESD-Schutzstrukturen ist es, bei Auftreten von ESD die dabei entstehenden Ladungen unschädlich über ihre Entladepfade abzuleiten. Im Falle eines Feldoxidtransistors als ESD-Schutzstruktur bildet beispielsweise sein Kanal den Entladepfad.

EP-A-0 253 105 offenbart einen integrierten Schaltkreis mit einer ESD-Schutzschaltung.

Aufgabe der Erfindung ist es, eine integrierte Schaltung zu schaffen, die einen verbesserten ESD-Schutz aufweist.

Diese Aufgabe wird durch eine integrierte Schaltung gemäß Anspruch 1 gelöst.

Fortbildungen der Erfindung sind in den abhängigen Ansprüchen gekennzeichnet.

Die Erfindung beruht auf der Erkenntnis, daß zwei benachbarte dotierte Bereiche vom gleichen Leitungstyp, zwischen denen sich ein isolierender Bereich befindet, die mit je einem Anschlußpad der integrierten Schaltung verbunden sind und die einen parasitären, also schaltungstechnisch nicht vorgesehenen, Feldeffekttransistor bilden, durch ESD besonders gefährdet sind.

Die Erfindung wird im folgenden anhand der Zeichnung näher erläutert:

Figuren 1 und 2 zeigen Details von Ausführungsbeispielen der Erfindung in Querschnittdarstellungen.

Figur 3 zeigt ein Ausführungsbeispiel in einer Schaltskizze.

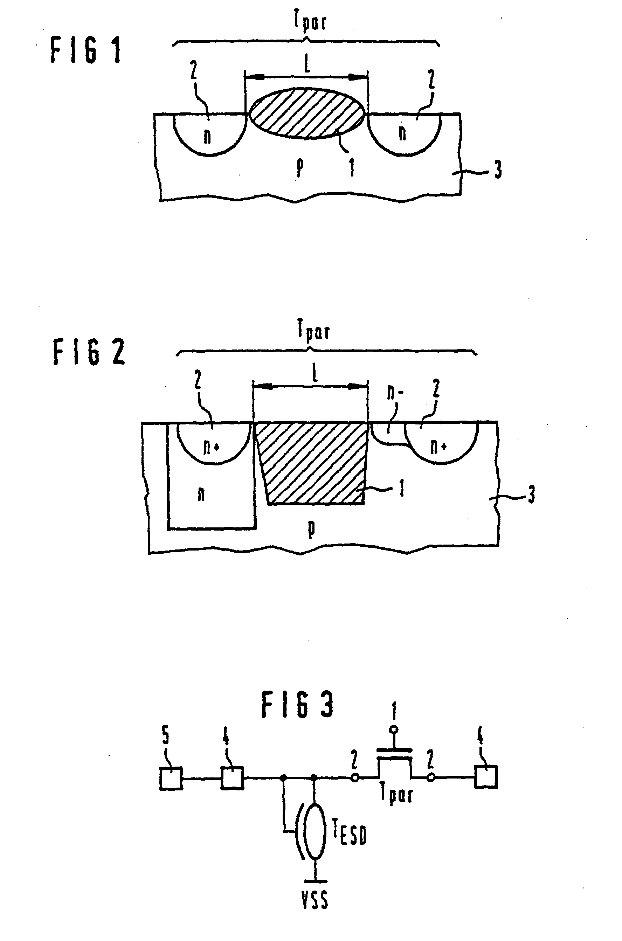

Bei dem Ausführungsbeispiel nach Figur 1 sind an der Oberfläche eines Substrates 3 zwei in einer lateralen Richtung benachbarte dotierte Bereiche 2 angeordnet, zwischen denen sich ein isolierender Bereich 1 befindet. Der isolierende Bereich 1 in Figur 1 ist ein sogenannter LOCOS-Bereich (LOCOS = Local. Oxidation of Silicon). Die dotierten Bereiche 2 und der isolierende Bereich 1 bilden ein parasitäres Halbleiterelement Tpar, in diesem Fall einen parasitären Transistor.

Die dotierten Bereiche 2 sind vom gleichen Leitungstyp, beim vorliegenden Ausführungsbeispiel sind sie n-dotiert. Bei anderen Ausführungsbeispielen der Erfindung können sie jedoch auch beide p-dotiert sein. Die Dotierkonzentration sowie die Art des Dotierstoffes kann jedoch bei den dotierten Bereichen 2 unterschiedlich sein. Die dotierten Bereiche 2 können sich statt im Substrat 3 auch beispielsweise in einer Epitaxieschicht befinden. Bei den dotierten Bereichen 2 kann es sich entweder um Diffusionsbereiche (wie dargestellt), um Wannen oder um sogenannte LDD-Gebiete (LDD = Lightly Doped Drain) oder um eine Kombination aus diesen Alternativen handeln. LDD-Gebiete sind Draingebiete, die an ihrem Rand eine geringere Dotierkonzentration als in ihrem Inneren aufweisen.

Das Substrat 3 ist vom zu demjenigen der dotierten Bereiche 2 entgegengesetzten Leitungstyp, in diesem Fall also p-dotiert.

Beim Ausführungsbeispiel nach Figur 2 ragt der isolierende Bereich 1 grabenförmig in das Substrat 3 hinein (Trenchisolation). Bei anderen Ausführungsbeispielen kann der isolierende Bereich 1 als eine Kombination aus dem in Figur 1 dargestellten LOCOS-Bereich und der Trenchisolation realisiert sein.

Der linke dotierte Bereich 2 in Figur 2 ist als n⁺-Diffusion in einer n-Wanne realisiert, der rechte dotierte Bereich als LDD-Bereich.

Derartige parasitäre Transistoren Tpar liegen beispielsweise dort vor, wo die dotierten Bereiche 2 Drain- bzw. Source-Gebiete von zwei verschiedenen, benachbarten Transistoren sind, die schaltungstechnisch vorgesehen, also nicht parasitär sind. Einer der dotierten Bereiche 2 kann jedoch auch z.B. ein Guardring sein.

Figur 3 zeigt in einem groben Schaltbild anhand eines Ausführungsbeispiels der Erfindung, dessen parasitärer Transistor gemäß Figur 1 oder Figur 2 gestaltet sein kann, daß die dotierten Bereiche 2 mit je einem Anschlußpad 4 der integrierten Schaltung verbunden sind. Eines der Anschlußpads 4 ist wiederum mit einem Anschlußpin 5 der integrierten Schaltung verbunden. Eine solche Verbindung wird gewöhnlich durch sogenannte Bonddrähte hergestellt. Die Anschlußpins 5 sind externe Anschlüsse der integrierten Schaltung. Das andere Anschlußpad 4 ist mit keinem Anschlußpin 5 verbunden. Es kann beispielsweise einen Meßpunkt darstellen, der mittels einer Meßspitze kontaktierbar ist. Derartige Anschlußpads 4 sind während der Durchführung von Messungen ebenso wie die mit Anschlußpins 5 verbundenen Anschlußpads 4 durch ESD gefährdet.

Bei anderen Ausführungsformen der Erfindung können beide Anschlußpads 4 mit je einem Anschlußpin 5 verbunden sein oder keines der beiden.

Figur 3 zeigt weiterhin eine ESD-Schutzstruktur TESD in Form eines Feldoxidtransistors, der mit seiner Kanalstrecke (dies ist sein Entladepfad) zwischen eines der Anschlußpads 4 bzw. den entsprechenden dotierten Bereich 2 und ein Versorgungspotential VSS der integrierten Schaltung, in diesem Fall Masse, geschaltet ist. Sein Gate ist ebenfalls mit dem Anschlußpad 4 verbunden. Eine solche ESD-Schutzstruktur TESD kann bei anderen Ausführungsformen der Erfindung auch bei beiden dotierten Bereichen 2 vorgesehen sein.

Im allgemeinen sind bei integrierten Schaltungen alle Anschlußpins 5 einer integrierten Schaltung mit mindestens einer ESD-Schutzstruktur TESD versehen, die mit unterschiedlichen Versorgungspotentialen, beispielsweise Masse und Potential VDD, verbunden sein können. Es ist auch bekannt, zwischen zwei Anschlußpads 4, die mit Anschlußpins 5 verbunden sind, eine ESD-Schutzstruktur TESD vorzusehen. Letzteres ist insbesondere der Fall, wenn es sich bei diesen beiden Anschlußpins 5 um Versorgungspotentialanschlüsse handelt.

Erfindungsgemäß ist nun vorgesehen, daß die Länge L des isolierenden Bereiches 1 in der lateralen Richtung größer als oder gleich der Länge des längsten Entladepfades der mit den Anschlußpads 4 verbundenen ESD-Schutzstrukturen TESD ist. Hierdurch ist die ESD-Festigkeit des parasitären Transistors Tpar erhöht, da sein ohmscher Widerstand mit der Länge L des isolierenden Bereiches 1 zunimmt. Je größer diese Länge L ist, desto hochohmiger ist der parasitäre Transistor Tpar. Erfindungsgemäß ist die Dimensionierung des parasitären Transistors Tpar von derjenigen der ESD-Schutzstrukturen TESD abhängig. Da diese bereits auf eine hohe ESD-Festigkeit ausgelegt sind, erreicht man auf die geschilderte Weise ebenfalls eine hohe ESD-Festigkeit des parasitären Transistors Tpar.

Versuche haben ergeben, daß eine besonders hohe ESD-Festigkeit des parasitären Transistors Tpar erzielt wird, wenn die Länge L des isolierenden Bereiches 1 mindestens gleich dem 1,5fachen der Länge des längsten Entladepfades der ESD-Schutzstrukturen TESD beträgt.

Bekannterweise ist die Kanalweite einer ESD-Schutzstruktur TESD in Form eines Feldoxidtransistors im allgemeinen sehr viel größer als diejenige anderer Strukturen, wie beispielsweise die der parasitären Transistoren Tpar. Bei gleichem Stromfluß durch eine derartige ESD-Schutzstruktur TESD und einen solchen parasitären Transistor Tpar ergibt sich somit im ersteren Fall eine sehr viel geringere Stromdichte. Durch die genannte erfindungsgemäße Dimensionierung des parasitären Transistors Tpar wird dieser aber hochohmiger als die ESD-Schutzstrukturen TESD, so daß bei einer ESD-bedingten Überspannung gleicher Höhe der Entladestrom über den parasitären Transistor Tpar geringer ist als über die ESD-Schutzstruktur TESD und sich eine geringere Stromdichte ergibt, so daß die ESD-Festigkeit des parasitären Transistors Tpar erhöht ist.

## Patentansprüche

1. Integrierte Schaltung mit folgenden Merkmalen:
- sie weist einen isolierenden Bereich (1) auf, der in ein Substrat (3) von einem ersten Leitungstyp hineinrget, im Substrat (3) befinden sich zwei voneinander getrennte direktbenachbarte dotierte Bereiche (2,2) von einem zweiten, dem ersten entgegengesetzten Leitungstyp, zwischen den dotierten Bereichen befindet sich in einer lateralen Richtung der isolierende Bereich (1), von den dotierten Bereichen ist einer mit einem ersten, der andere mit einem anderen zweiten Anschlußpad (4, 4) der integrierten Schaltung direktelektrisch verbunden,
- die zwei dotierten Bereiche (2), und der isolierende Bereich (1) bilden einen parasitären Halbleitertransistor (Tpar),
- mindestens eines der Anschlußpads (4, 4) ist über mindestens eine ESD-Schutzstruktur (TESD) mit einem Versorgungspotential anschluß (VSS) der integrierten Schaltung verbunden,
- die mindestens eine ESD-Schutzstruktur inform eines Feldoxidtransistors (TESD) weist einen Entladepfad in Form eines kanals des Feldoxidtransistors auf, über den im Falle einer elektrostatischen Entladung der Entladestrom an das Versorgungspotential (VSS) abgeleitet wird,
- die Länge (L) des isolierenden Bereichs (1) in der lateralen Richtung ist größer als oder gleich der Länge des längsten Entladepfads der mindestens einen ESD-Schutzstruktur (TESD).

2. Integrierte Schaltung nach Anspruch 1,
**dadurch gekennzeichnet,**
**daß** die Länge (L) des isolierenden Bereichs (1) mindestens dem 1,5fachen der Länge des längsten Entladepfades der ESD-Schutzstrukturen (TESD) entspricht.

3. Integrierten Schaltung nach einem der vorstehenden Ansprüche,
**dadurch gekennzeichnet,**
**daß** eines der Anschlußpads (4) mit einem Anschlußpin (5) der integrierten Schaltung verbunden ist.

4. Integrierte Schaltung nach einem der vorstehenden Ansprüche,
**dadurch gekennzeichnet,**
**daß** eines der Anschlußpads (4) mit einer Elektrode, beispielsweise einer Meßspitze, verbindbar ist.

5. Integrierte Schaltung nach einem der vorstehenden Ansprüche,
**dadurch gekennzeichnet,**
**daß** der isolierende Bereich (1) ein LOCOS-Bereich ist.

6. Integrierte Schaltung nach einem der vorstehenden Ansprüche,
**dadurch gekennzeichnet,**
**daß** der isolierende Bereich (1) eine Trenchisolation ist.

## Claims

1. Integrated circuit having the following features:
- said circuit has an insulating region (1) which projects into a substrate (3) of a first conductivity type, two mutually separated directly adjacent doped regions (2, 2) of a second conductivity type which is the opposite of the first conductivity type, are located in the substrates (3), the insulating region (1) is located in a lateral direction between the doped regions, one of the doped regions is directly electrically connected to a first, the other to another second connecting pad (4, 4) of the integrated circuit,
- the two doped regions (2) and the insulating region (1) form a parasitic semiconductor transistor (Tpar),
- at least one of the connecting pads (4, 4) is connected via at least one ESD protective structure (TESD) to one supply potential connection (VSS) of the integrated circuit,
- the at least one ESD protective structure (TESD) in the form of a field-oxide transistor has a discharge path in the form of a channel of the field-oxide transistor, via which the discharge current is dissipated to the supply potential (VSS) in the event of an electrostatic discharge,
- the length (L) of the insulating region (1) in the lateral direction is greater than or equal to the length of the longest discharge path of the at least one ESD protective structure (TESD).

2. Integrated circuit according to Claim 1,
**characterized**
**in that** the length (L) of the insulating region (1) corresponds to at least 1.5 times the length of the longest discharge path of the ESD protective structures (TESD).

3. Integrated circuit according to one of the preceding claims,
**characterized**
**in that** one of the connecting pads (4) is connected to a connecting pin (5) of the integrated circuit.

4. Integrated circuit according to one of the preceding claims,
**characterized**
**in that** one of the connecting pads (4) can be connected to an electrode, for example to a measurement probe.

5. Integrated circuit according to one of the preceding claims,
**characterized**
**in that** the insulating region (1) is a LOCOS region.

6. Integrated circuit according to one of the preceding claims,
**characterized**
**in that** the insulating region (1) is trench insulation.

## Revendications

1. Circuit intégré ayant les caractéristiques suivantes :
- il comporte une zone (1) d'isolation, qui pénètre dans un substrat (3) d'un premier type de conductivité, substrat (3) dans lequel se trouvent deux zones (2, 2) dopées, directement voisines et séparées l'une de l'autre, d'un deuxième type de conductivité opposée au premier, la zone (1) d'isolement se trouvant entre les zones dopées dans une direction latérale, l'une des zones dopées étant reliée directement du point de vue électrique à un premier plot de raccordement et l'autre à un autre deuxième plot (4, 4) de raccordement du circuit intégré,
- les deux zones (2) dopées et la zone (1) d'isolement forment un transistor (Tpar) parasite à semi-conducteur,
- au moins l'un des plots (4, 4) de raccordement étant relié par au moins une structure (TESD) de protection ESD à une bome (VSS) de potentiel d'alimentation du circuit intégré,
- la au moins une structure (TESD) de protection ESD sous la forme d'un transistor à oxyde de champ a un trajet de décharge sous la forme d'un canal du transistor à oxyde de champ, par lequel le courant de décharge est évacué sur le potentiel (VSS) d'alimentation dans le cas d'une décharge électrostatique,
- la longueur (L) de la zone (1) d'isolement dans la direction latérale est plus grande ou égale à la longueur du trajet de décharge le plus long de la au moins une structure (TESD) de protection ESD.

2. Circuit intégré suivant la revendication 1, **caractérisé en ce que** la longueur (L) de la zone (1) d'isolement correspond à au moins 1,5 fois la longueur du trajet de décharge le plus long des structures (TESD) de protection ESD.

3. Circuit intégré suivant l'une des revendications précédentes, **caractérisé en ce que** l'un des plots (4) de raccordement est relié à une broche (5) de raccordement du circuit intégré.

4. Circuit intégré suivant l'une des revendications précédentes, **caractérisé en ce que** l'un des plots (4) de raccordement peut être relié à une électrode, par exemple à une pointe de mesure.

5. Circuit intégré suivant l'une des revendications précédentes, **caractérisé en ce que** la zone (1) d'isolement est une zone LOCOS.

6. Circuit intégré suivant l'une des revendications précédentes, **caractérisé en ce que** la zone (1) d'isolement est un isolement par sillon.
